# FASCICULE DE BREVET EUROPEEN

(11) **EP 3 206 038 B1**
(45) Date de publication et mention de la délivrance du brevet: **07.04.2021**
(21) Numéro de dépôt: 17156116.0
(22) Date de dépôt: 14.02.2017
(51) Int. Cl.: G01R 19/00

(54) **DISPOSITIF DE MESURE D'UN COURANT ÉLECTRIQUE GÉNÉRÉ PAR UN AMPLIFICATEUR ACOUSTIQUE POUR ACTIONNER UNE ENCEINTE ACOUSTIQUE**
VORRICHTUNG ZUM MESSEN EINES ELEKTRISCHEN STROMS, DER VON EINEM AKUSTISCHEN VERSTÄRKER ERZEUGT WIRD, UM EINE LAUTSPRECHERBOX ZU AKTIVIEREN
DEVICE FOR MEASURING AN ELECTRIC CURRENT GENERATED BY AN ACOUSTIC AMPLIFIER IN ORDER TO ACTUATE A SPEAKER SYSTEM

(30) Priorité: 15.02.2016 FR 1651213
(43) Date de publication de la demande: 16.08.2017
(73) Titulaire: L-Acoustics, 91462 Marcoussis Cedex (FR)
(72) Inventeur: HEIL, Christian, LONDRES, NW3 1TX (GB); VAYSSE, Pierre, 92160 Antony (FR)
(74) Mandataire: Novagraaf Technologies

(56) Documents cités:
- EP-A1- 2 632 174
- WO-A1-2009/020535
- US-A1- 2015 181 335
- US-A1- 2015 219 690

## Description

### Domaine technique

La présente invention se rapporte à un dispositif de mesure d'un courant électrique généré par un amplificateur acoustique pour actionner une enceinte acoustique.

### État de la technique

Dans le domaine de l'électro-acoustique et plus particulièrement de la génération de sons par la transformation d'un signal électrique en onde acoustique en utilisant des enceintes, il est important de connaître précisément le courant électrique consommé par ces enceintes, c'est-à-dire l'intensité instantanée du signal électrique d'alimentation des enceintes.

Le domaine électroacoustique se caractérise par des contraintes particulières :
- Des tensions de mode commun alternatives qui peuvent être très élevées (une centaine de volts) ;
- Des courants alternatifs qui varient dans une grande plage de valeurs, jusqu'à 50A en fonction de l'impédance de l'enceinte ;
- Des dynamiques en courant et/ou tension de plus d'une centaine de décibels ; et
- Un besoin d'excellente précision sur une large gamme de fréquence (de 20Hz à 20kHz) alors que les hautes fréquences augmentent les perturbations des mesures.

En effet, comme toute transformation énergétique, cette conversion électrique-acoustique génère de la chaleur et il est donc nécessaire de vérifier que la chaleur générée reste inférieure à un seuil prédéterminé. Ce paramètre est particulièrement significatif dans les enceintes professionnelles destinées à sonoriser de larges volumes car les énergies utilisées sont importantes. Or la puissance dissipée est proportionnelle au carré du courant/de l'intensité RMS du signal électrique. Ainsi connaître le courant consommé permet d'atteindre la puissance dissipée et donc la chaleur émise.

Cette connaissance précise du courant a également d'autres applications comme la connaissance précise de l'impédance des enceintes en fonction de la fréquence et la détection des haut-parleurs.

Pour mesurer cette intensité de signal électrique, les techniques classiques utilisent un amplificateur différentiel spécialisé comprenant une résistance en entrée (shunt de mesure du courant) permettant de convertir une intensité en une différence de potentiel.

Toutefois, ce type d'amplificateur de détection de courant est intrinsèquement sensible à la tension de mode commun présente sur le shunt de mesure et nécessite par conséquent l'utilisation d'un amplificateur différentiel de précision couteux si on souhaite atteindre les précisions nécessaires en électroacoustique.

Il existe donc un réel besoin d'un dispositif de mesure d'intensité palliant ce défaut en particulier d'un dispositif permettant de maîtriser l'impact de la mesure sur le signal électrique mesuré, réduire les coûts et d'améliorer la sensibilité et la précision de la mesure.

Un état de la technique pertinent est divulgué dans le document US 2015/219690.

### Description de l'invention

Pour résoudre un ou plusieurs des inconvénients cités précédemment, un dispositif de mesure d'un courant électrique bidirectionnel généré par un amplificateur acoustique pour actionner une enceinte acoustique, le dispositif étant adapté pour fonctionner quelque soit le sens du courant et la polarité de tension de mode commun, comprend :
- une résistance de shunt positionnée en série entre l'amplificateur acoustique et l'enceinte acoustique ;
- un convertisseur tension-intensité dont les entrées sont connectées aux pôles de la résistance de shunt, ledit convertisseur étant adapté pour transformer proportionnellement la différence de tension aux pôles du shunt en une intensité de signal ;
- un premier miroir de courant dont l'entrée est connectée à la sortie du convertisseur tension-intensité et dont la sortie est connectée à
- un convertisseur intensité-tension de telle sorte que la tension en sortie du convertisseur intensité-tension est proportionnelle à l'intensité de signal.

Le dispositif comprend en outre un générateur de courant de polarisation constant connecté à une entrée du convertisseur tension-intensité et dont la sortie est connectée au convertisseur intensité-tension via un second miroir de courant, ledit générateur de courant de polarisation étant adapté pour générer un courant de polarisation tel que le dispositif fonctionne en mode linéaire et sans saturation quelque soit le courant électrique généré par l'amplificateur acoustique.

Des caractéristiques ou des modes de réalisation particuliers, utilisables seuls ou en combinaison, sont :
- le premier et le second miroirs de courant comprennent :
   - une première résistance et
   - un premier générateur de tension de polarisation en série entre une connexion de signal d'entrée et la masse,
- un amplificateur opérationnel dont l'entrée non-inverseuse est connectée sur le signal d'entrée en amont de la première résistance et l'entrée inverseuse est connectée entre la première résistance et le premier générateur de tension de polarisation via une seconde résistance et dont la sortie est connectée à
- la grille d'un transistor MOSFET, la source dudit transistor MOSFET étant connecté à l'entrée inverseuse de l'amplificateur opérationnel, et le drain générant le courant miroir, étant connecté à un plot de sortie ;
- le générateur de courant de polarisation comprend :
   - un deuxième générateur de tension adapté pour générer une tension de référence (Vref) entre l'entrée non-inverseuse d'un amplificateur opérationnel et d'un troisième générateur de tension de polarisation négative dont le second pôle est connecté à la masse, et
   - l'entrée inverseuse de l'amplificateur opérationnel est connectée au troisième générateur de tension via une résistance ainsi qu'à la source
- d'un transistor MOSFET de type N dont le drain fournit le courant de polarisation sur un plot de sortie.
- le convertisseur tension-intensité comprend :
   - un amplificateur opérationnel dont l'entrée inverseuse est connectée à l'entrée de la résistance de shunt via une seconde résistance, et l'entrée non-inverseuse est connectée directement à la sortie de la résistance de shunt, et dont la sortie est connectée à
   - la grille d'un transistor MOSFET de type N dont la source est connectée à l'entrée inverseuse de l'amplificateur opérationnel et le drain fournit l'intensité de signal.

### Brève description des figures

L'invention sera mieux comprise à la lecture de la description qui suit, faite uniquement à titre d'exemple, et en référence aux figures en annexe dans lesquelles :
- La figure 1 représente un schéma électronique général d'un dispositif de mesure selon un mode de réalisation de l'invention ;
- La figure 2 représente une vue détaillée du miroir de courant de signal du dispositif de la figure 1 ;
- La figure 3 représente une vue détaillée du miroir de courant de polarisation du dispositif de la figure 1 ; et
- La figure 4 représente une vue détaillée de la source de courant de polarisation du dispositif de la figure 1.

### Modes de réalisation

En préliminaire, on rappellera que le courant électrique généré par un amplificateur acoustique pour actionner une enceinte acoustique a les caractéristiques d'un courant alternatif variable aussi bien en intensité/tension qu'en fréquence sur une plage de quelques Hz à environ 20kHz.

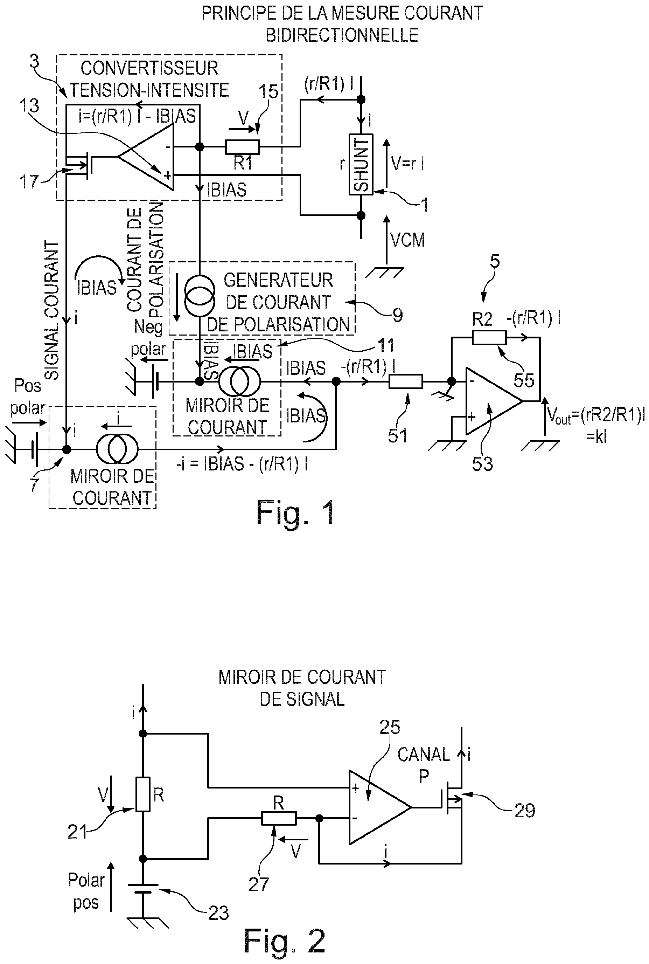

En référence à la figure 1, un dispositif de mesure d'un courant électrique généré par un amplificateur acoustique pour actionner une enceinte acoustique comprend une résistance de shunt 1 positionnée en série entre l'amplificateur acoustique et l'enceinte acoustique. Cette résistance à une valeur ohmique r très faible, de l'ordre de 2mΩ, afin de n'interférer que de façon minimale sur le signal électrique.

Une première conversion tension-intensité est réalisée par un convertisseur tension-intensité 3 dont les entrées sont connectées aux pôles de la résistance de shunt. Le convertisseur est adapté pour transformer proportionnellement la différence de tension aux pôles de la résistance de shunt 1 en une intensité de signal.

La sortie du convertisseur tension-intensité 3 est connectée à un convertisseur intensité-tension 5 par l'intermédiaire d'un premier miroir de courant 7, aussi appelé miroir de courant de signal. Ainsi, la tension en sortie du convertisseur intensité-tension 5 est proportionnelle à l'intensité de signal.

De plus, afin de permettre au circuit de fonctionner en permanence dans un mode linéaire et sans saturation quelque soit le sens du courant et la polarité de tension de mode commun, le dispositif comprend également un générateur de courant de polarisation constant 9. Ce courant de polarisation est nommé Ibias dans la suite.

Le générateur de courant de polarisation constant 9 est connecté à une entrée du convertisseur tension-intensité 3 et la sortie est connectée au convertisseur intensité tension 5 via un second miroir de courant 11.

Le générateur de courant de polarisation 9 est donc adapté pour générer un courant de polarisation tel que le dispositif fonctionne en mode linéaire et sans saturation quelque soit le courant électrique généré par l'amplificateur acoustique.

Nous allons décrire maintenant plus en détail le mode de réalisation de chaque bloc avant d'en expliciter le fonctionnement.

Le convertisseur tension-intensité 3 comprend :
- un amplificateur opérationnel 13 dont l'entrée inverseuse est connectée à l'entrée de la résistance de shunt 1 via une seconde résistance 15 de valeur ohmique R1, et l'entrée non-inverseuse est connectée directement à la sortie de la résistance de shunt 1, et dont la sortie est connectée à
- la grille d'un transistor MOSFET de type N 17 dont la source est également connectée à l'entrée inverseuse de l'amplificateur opérationnel et le drain fournit l'intensité de signal.

le premier miroir de courant 7 dit miroir de courant de signal comprend, figure 2 :
- une première résistance 21 et
- un premier générateur de tension de polarisation positive 23 en série entre une connexion de signal d'entrée et la masse,
- un amplificateur opérationnel 25 dont l'entrée non-inverseuse est connectée sur le signal d'entrée en amont de la première résistance 21 et l'entrée inverseuse est connectée entre la première résistance 21 et le premier générateur de tension de polarisation 23 via une seconde résistance 27 et dont la sortie est connectée à
- la grille d'un transistor MOSFET 29 de type P, la source dudit transistor MOSFET étant connecté à l'entrée inverseuse de l'amplificateur opérationnel, et le drain générant le courant miroir de signal, étant connectée à un plot de sortie.

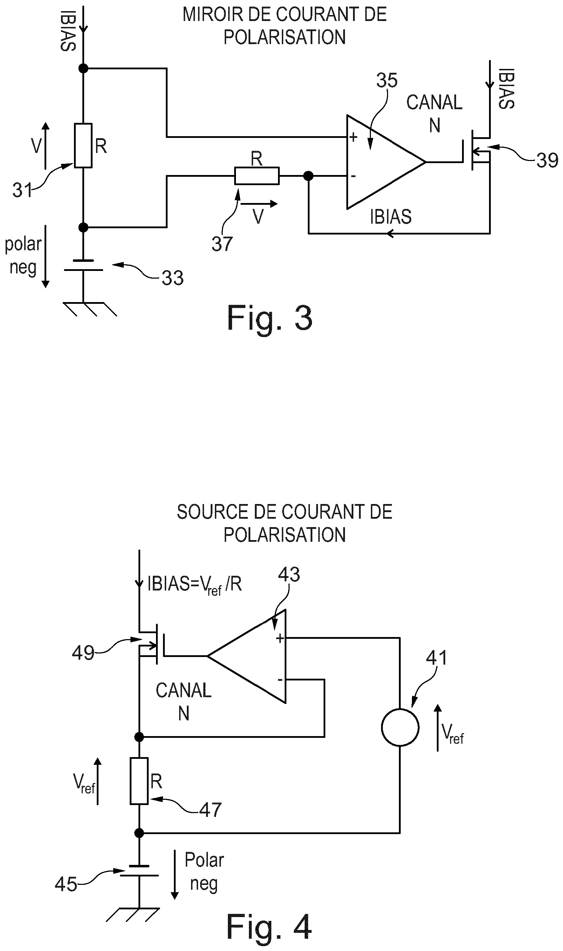

Le second miroir de courant 11, figure 3, a une structure similaire au premier miroir de courant 7. Il comprend en effet :
- une première résistance 31 et
- un premier générateur de tension de polarisation négative 33 en série entre une connexion de signal d'entrée et la masse,
- un amplificateur opérationnel 35 dont l'entrée non-inverseuse est connectée sur le signal d'entrée en amont de la première résistance 31 et l'entrée inverseuse est connectée entre la première résistance 31 et le premier générateur de tension de polarisation 33 via une seconde résistance 37 et dont la sortie est connectée à
- la grille d'un transistor MOSFET 39 de type N, la source dudit transistor MOSFET étant connecté à l'entrée inverseuse de l'amplificateur opérationnel, et le drain générant le courant miroir de polarisation, étant connecté à un plot de sortie.

Ainsi les deux différences entre les deux miroirs de courant portent sur le type des transistors MOSFET et sur le signe de la polarisation des générateurs de tension.

Enfin, le générateur de courant de polarisation 9 comprend, figure 4 :
- un deuxième générateur de tension 41 adapté pour générer une tension de référence (Vref) entre l'entrée non-inverseuse d'un amplificateur opérationnel 43 et d'un troisième générateur de tension de polarisation négative 45 dont le second pôle est connecté à la masse, et
- l'entrée inverseuse de l'amplificateur opérationnel est connectée au troisième générateur de tension 45 via une résistance 47 ainsi qu'à la source
- d'un transistor MOSFET de type N 49 dont le drain fourni le courant de polarisation sur un plot de sortie.

Le convertisseur intensité-tension 5 comprend, figure 1, en entrée une résistance 51 connectée en série avec l'entrée inverseuse d'un amplificateur opérationnel 53 dont l'entrée non-inverseuse est connectée à la masse. La sortie de l'amplificateur opérationnel 53 reboucle sur l'entrée inverseuse de celui-ci par l'intermédiaire d'une résistance 55.

Ainsi, en fonctionnement, le courant de signal et le courant de polarisation constant sont additionnés et suivent le « chemin de signal » consistant dans le premier miroir de courant 7.

Le courant de polarisation est également conduit par le « chemin de polarisation » comprenant le générateur de courant de polarisation 9 et le second miroir de courant 11.

Aussi, en entrée du convertisseur intensité-tension 5, les courants du « chemin de signal » et du « chemin de polarisation » sont additionnés mais comme le courant de polarisation circule en sens opposé sur ces deux chemins, il est annulé en entrée du convertisseur intensité-tension.

On constate qu'on a décrit un circuit de mesure qui n'utilise que des composants classiques.

Typiquement, les amplificateurs opérationnels sont bas bruit et fonctionnent à des niveaux de gain relativement faibles.

Il est à noter également que le fonctionnement utilisant l'annulation du courant de polarisation en entrée du convertisseur intensité-tension offre également l'avantage de supprimer les courants parasites des transistors MOSFET.

Par ailleurs, l'utilisation de sources de courant contrôlées limite par nature les effets de la tension de mode commun par comparaison avec des montages différentiels basés sur la détection de tension.

On constate ainsi qu'on a décrit un dispositif de mesure bas coût particulièrement bien adapté au domaine de l'électroacoustique.

En effet, par rapport aux contraintes du domaine,le dispositif présente une bidirectionnalité en tension de mode commun comme en courant (par l'ajout d'un courant « Ibias »). Et l'utilisation d'un générateur de courant pour transformer la tension aux bornes du shunt en courant permet d'excellentes performances de réjection de la tension en mode commun d'environ 90dB.

Le montage est également capable de mesurer un courant de fréquence nulle (courant continu). Il permet, grâce à sa grande immunité à la tension de mode commun, la détection d'enceinte avec un bon rapport signal à bruit même en présence de signal d'excitation faible. La bande passante du montage étant principalement limitée par les performances des amplificateurs opérationnels, elle autorise une fréquence d'utilisation élevée. Cette caractéristique offre dans le domaine fréquentiel audio une faible atténuation et un faible déphasage du signal dans les aigus. Le montage permet la réalisation d'une protection en courant rapide. De par sa grande fidélité il peut être utilisé pour l'asservissement en courant des enceintes (réalisation d'amplificateur à transconductance). Ainsi,ce montage permet de détecter la présence de l'enceinte, de mesurer l'impédance de celle-ci et de la protéger, de contrôler le courant dans l'enceinte pour la piloter en courant plutôt qu'en tension. Cette dernière utilisation a l'avantage d'éliminer les distortions propres de l'enceinte et d'avoir un contrôle plus précis qu'un contrôle en tension.

L'invention a été illustrée et décrite en détail dans les dessins et la description précédente. Celle-ci doit être considérée comme illustrative et donnée à titre d'exemple et non comme limitant l'invention a cette seule description. De nombreuses variantes de réalisation sont possibles.

Dans les revendications, le mot « comprenant » n'exclut pas d'autres éléments et l'article indéfini « un/une » n'exclut pas une pluralité.

## Revendications

1. Dispositif de mesure d'un courant électrique bidirectionnel généré par un amplificateur acoustique pour actionner une enceinte acoustique, ledit dispositif étant adapté pour fonctionner quelque soit le sens du courant et la polarité de tension de mode commun et comprenant :
• une résistance de shunt (1) positionnée en série entre l'amplificateur acoustique et l'enceinte acoustique ;
• un convertisseur tension-intensité (3) dont les entrées sont connectées aux pôles de la résistance de shunt (1), ledit convertisseur étant adapté pour transformer proportionnellement la différence de tension aux pôles du shunt en une intensité de signal ;
• un premier miroir de courant (7) dont l'entrée est connectée à la sortie du convertisseur tension-intensité (3) et dont la sortie est connectée à
• un convertisseur intensité-tension (5) de telle sorte que la tension en sortie du convertisseur intensité-tension est proportionnelle à l'intensité de signal ;
ledit dispositif comprenant en outre :
• un générateur de courant de polarisation constant (9) connecté à une entrée du convertisseur tension-intensité (3) et dont la sortie est connectée au convertisseur intensité tension (5) via un second miroir de courant (11), ledit générateur de courant de polarisation (9) étant adapté pour générer un courant de polarisation tel que le dispositif fonctionne en mode linéaire et sans saturation quelque soit le courant électrique généré par l'amplificateur acoustique.

2. Dispositif selon la revendication 1, **caractérisé en ce que** le premier et le second miroirs de courant comprennent :
• une première résistance (21, 31) et
• un premier générateur de tension de polarisation (23, 33) en série entre une connexion de signal d'entrée et la masse,
• un amplificateur opérationnel (25, 35) dont l'entrée non-inverseuse est connectée sur le signal d'entrée en amont de la première résistance et l'entrée inverseuse est connectée entre la première résistance et le premier générateur de tension de polarisation via une seconde résistance (27, 37) et dont la sortie est connectée à
• la grille d'un transistor MOSFET (29, 39), la source dudit transistor MOSFET étant connecté à l'entrée inverseuse de l'amplificateur opérationnel, et le drain générant le courant miroir, étant connecté à un plot de sortie.

3. Dispositif selon la revendication 1 ou 2, **caractérisé en ce que** le générateur de courant de polarisation comprend :
• un deuxième générateur de tension (41) adapté pour générer une tension de référence (Vref) entre l'entrée non-inverseuse d'un amplificateur opérationnel (43) et d'un troisième générateur de tension de polarisation négative (45) dont le second pôle est connecté à la masse, et
• l'entrée inverseuse de l'amplificateur opérationnel est connectée au troisième générateur de tension via une résistance (47) ainsi qu'à la source
• d'un transistor MOSFET (49) de type N dont le drain fourni le courant de polarisation sur un plot de sortie.

4. Dispositif selon la revendication 1, 2, ou 3, **caractérisé en ce que** le convertisseur tension-intensité comprend :
• un amplificateur opérationnel (13) dont l'entrée inverseuse est connectée à l'entrée de la résistance de shunt (1) via une seconde résistance (15), et l'entrée non-inverseuse est connectée directement à la sortie de la résistance de shunt, et dont la sortie est connectée à
• la grille d'un transistor MOSFET (17) de type N dont la source est connectée à l'entrée inverseuse de l'amplificateur opérationnel et le drain fourni l'intensité de signal.

## Patentansprüche

1. Vorrichtung zur Messung eines bidirektionalen elektrischen Stroms, der von einem akustischen Verstärker erzeugt wird, um eine Lautsprecherbox in Betrieb zu setzen, wobei die Vorrichtung geeignet ist, unabhängig von der Richtung des Stroms und der Gleichtakt-Spannungspolarität zu arbeiten und enthält:
• einen Shunt-Widerstand (1), der zwischen dem akustischen Verstärker und der Lautsprecherbox in Reihe positioniert ist;
• einen Spannung-Stärke-Wandler (3), dessen Eingänge mit den Polen des Shunt-Widerstands (1) verbunden sind, wobei der Wandler geeignet ist, die Spannungsdifferenz an den Polen des Shunts proportional in eine Signalstärke umzuwandeln;
• einen ersten Stromspiegel (7), dessen Eingang mit dem Ausgang des Spannung-Stärke-Wandlers (3) und dessen Ausgang mit
• einem Stärke-Spannung-Wandler (5) derart verbunden ist, dass die Spannung am Ausgang des Stärke-Spannung-Wandlers proportional zur Signalstärke ist;
wobei die Vorrichtung außerdem enthält:
• einen Generator konstanten Polarisationsstroms (9), der mit einem Eingang des Spannung-Stärke-Wandlers (3) verbunden ist und dessen Ausgang mit dem Stärke-Spannung-Wandler (5) über einen zweiten Stromspiegel (11) verbunden ist, wobei der Polarisationsstromgenerator (9) geeignet ist, einen derartigen Polarisationsstrom zu erzeugen, dass die Vorrichtung im Linearmodus und ohne Sättigung arbeitet, unabhängig von dem vom akustischen Verstärker erzeugten elektrischen Strom.

2. Vorrichtung nach Anspruch 1, **dadurch gekennzeichnet, dass** der erste und der zweite Stromspiegel enthalten:
• einen ersten Widerstand (21, 31) und
• einen ersten Polarisationsspannungsgenerator (23, 33) in Reihe zwischen einer Eingangssignalverbindung und Masse,
• einen Operationsverstärker (25, 35), dessen nichtinvertierender Eingang mit dem Eingangssignal stromaufwärts vor dem ersten Widerstand verbunden ist, und der invertierende Eingang zwischen dem ersten Widerstand und dem ersten Polarisationsstromgenerator über einen zweiten Widerstand (27, 37) verbunden ist, und dessen Ausgang mit
• dem Gate eines MOSFET-Transistors (29, 39) verbunden ist, wobei die Source des MOSFET-Transistors mit dem invertierenden Eingang des Operationsverstärkers verbunden ist, und der den Spiegelstrom erzeugende Drain mit einem Ausgangskontaktstück verbunden ist.

3. Vorrichtung nach Anspruch 1 oder 2, **dadurch gekennzeichnet, dass** der Polarisationsstromgenerator enthält:
• einen zweiten Spannungsgenerator (41), der geeignet ist, eine Bezugsspannung (Vref) zwischen dem nichtinvertierenden Eingang eines Operationsverstärkers (43) und eines dritten Generators negativer Polarisationsspannung (45) zu erzeugen, dessen zweiter Pol mit Masse verbunden ist, und
• der invertierende Eingang des Operationsverstärkers mit dem dritten Spannungsgenerator über einen Widerstand (47) sowie mit der Source
• eines MOSFET-Transistors (49) des Typs N verbunden ist, dessen Drain den Polarisationsstrom an einem Ausgangskontaktstück liefert.

4. Vorrichtung nach Anspruch 1, 2 oder 3, **dadurch gekennzeichnet, dass** der Spannung-Stärke-Wandler enthält:
• einen Operationsverstärker (13), dessen invertierender Eingang mit dem Eingang des Shunt-Widerstands (1) über einen zweiten Widerstand (15) verbunden ist, und der nicht-invertierende Eingang direkt mit dem Ausgang des Shunt-Widerstands verbunden ist, und dessen Ausgang mit
• dem Gate eines MOSFET-Transistors (17) vom Typ N verbunden ist, dessen Source mit dem invertierenden Eingang des Operationsverstärkers verbunden ist und der Drain die Signalstärke liefert.

## Claims

1. A device for measuring a bidirectional electric current generated by an acoustic amplifier in order to actuate an acoustic speaker, said device being adapted to function whatever the direction of the current and the common mode voltage polarity and comprising:
• a shunt resistor (1) positioned in series between the acoustic amplifier and the acoustic speaker;
• a voltage-to-current converter (3), the inputs of which are connected to the terminals of the shunt resistor (1), said converter being capable of proportionally converting the difference in voltage across the terminals of the shunt to a signal intensity;
• a first current mirror (7), the input of which is connected to the output of the voltage-to-current converter (3) and the output of which is connected to
• a current-to-voltage converter (5) such that the output voltage of the current-to-voltage converter is proportional to the signal intensity;
said device additionally comprising:
• a constant bias current generator (9) connected to an input of the voltage-to-current converter (3) and the output of which is connected to the current-to-voltage converter (5) via a second current mirror (11), said bias current generator (9) being adapted to generate a bias current such that the device operates in linear mode and without saturation regardless of the electric current generated by the acoustic amplifier.

2. The device as claimed in claim 1, **characterized in that** the first and the second current mirrors comprise:
• a first resistor (21, 31) and
• a first bias voltage generator (23, 33) in series between an input signal connection and ground;
• an operational amplifier (25, 35), the non-inverting input of which is connected to the input signal upstream of the first resistor and the inverting input of which is connected between the first resistor and the first bias voltage generator by a second resistor (27, 37), and the output of which is connected to
• the gate of a MOSFET transistor (29, 39), the source of said MOSFET transistor being connected to the inverting input of the operational amplifier, and the drain of which, generating the mirror current, being connected to an output pad.

3. The device as claimed in claim 1 or 2, **characterized in that** the bias current generator comprises:
• a second voltage generator (41) adapted to generate a reference voltage (Vref) between the non-inverting input of an operational amplifier (43) and a third negative bias voltage generator (45), the second terminal of which is connected to ground; and
• the inverting input of the operational amplifier is connected to the third voltage generator via a resistor (47) as well as to the source
• of an n-type MOSFET transistor (49), the drain of which delivers the bias current to an output pad.

4. The device as claimed in claim 1, 2 or 3, **characterized in that** the voltage-to-current converter comprises:
• an operational amplifier (13), the inverting input of which is connected to the input of the shunt resistor (1) via a second resistor (15), the non-inverting input of which is directly connected to the output of the shunt resistor, and the output of which is connected to
• the gate of an n-type MOSFET transistor (17), the source of which is connected to the inverting input of the operational amplifier and the drain of which delivers the signal intensity.
